# EUROPEAN PATENT APPLICATION

(11) **EP 1 335 385 A2**
(43) Date of publication of application: **13.08.2003**
(21) Application number: 03250819.4
(22) Date of filing: 10.02.2003
(51) Int. Cl.: G11C 11/4096, G11C 7/10

(54) **Self-termination scheme**

(30) Priority: 08.02.2002 US 355288 P
(71) Applicant: ATI Technologies Inc., Markham, Ontario L3T 7X6 (CA); Elpida Memory Inc., Tokyo 104-0028 (JP)
(72) Inventor: Macri, Joseph, San Francisco, CA 94133 (US); Drapkin, Oleg, Richmond Hill, Ontario L4C0G6 (CA); Temkine,Grigori, Markham, Ontario L3P 4E7 (CA); Nagashima, Osamu, Tokyo 205 - 0001 (JP)
(74) Representative: Howe, Steven

(57) **Abstract**

The present invention provides a memory device with a N-MOS self-termination scheme which enables or disables the device to eliminate ringing and line reflections in a memory device such as a DDR SDRAM. The self-termination is achieved by using a weak N-MOS transistor. The N-MOS transistors are within the device and has an impedance of two to eight times of the characteristic impedance of a communication path in a memory device such as DRAM or SRDAM. The communication path is generally a read/write or command/address bus. The self-termination scheme terminates line reflections occurring in a device receiving data during non productive time duration of system clock. The present invention provides a method by which random access memories perform with faster settling time for data inputs and a high system performance.

## Description

The present invention relates to the field of computer memory devices. More specifically, the present invention relates to a self-termination scheme in a double data rate (DDR) synchronous dynamic random access memory (SDRAM) device.

With the advance in technologies in the field of computers and communications, the processing speeds of electronic devices have increased tremendously. As memory devices become faster in processing speed, design engineers are increasingly confronted with issues that were of minor significance when using slower devices. The most prominent of these issues is the line reflection. A line reflection causes signal distortion in a transmission line which ultimately results in malfunction of the entire system by overshooting or undershoots on a signal edge.

Every signal trace on a conventional memory circuit, such as a DRAM circuit, is a transmission line. This is the medium by which signals are transmitted within the varied electrical systems. As the edge rates and clock speeds increase in a system, impedance matching along the signal path is required. As signals travel through transmission lines they encounter discontinuities in impedance. These discontinuities being at the output of the signal driver and occur at every via and branch along a path until reaching a device input.

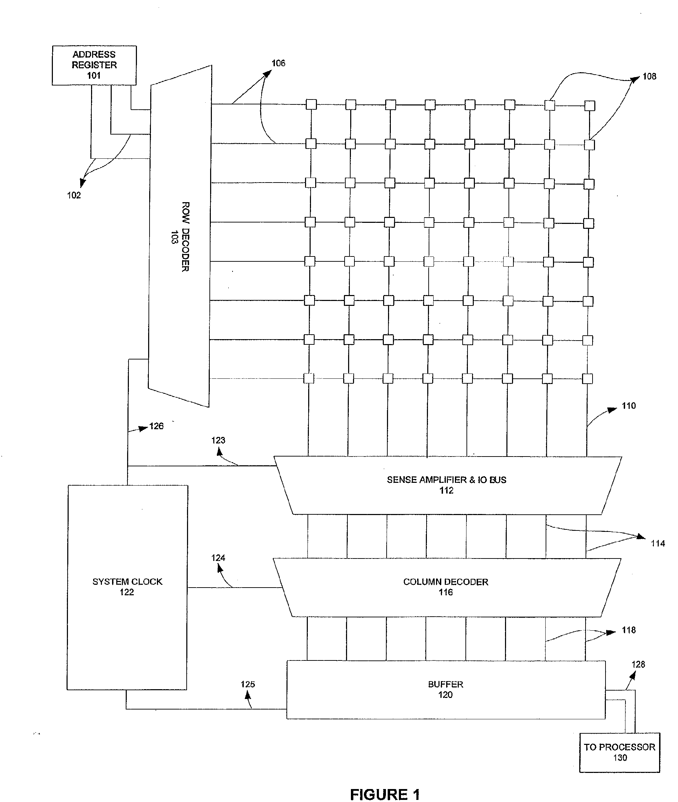

Figure 1 is an illustration of a conventional memory device such as a DDR SDRAM. A memory cell array 108 is connected to a row decoder 103 by word line bus 106. A row decoder 103 is connected to an address register 101 by an address line 102. A memory cell array 108 is connected to a sensing amplifier unit 112 by a bit line bus 110. A column decoder 116 is connected to the output of a sensing amplifier unit 112. The output of a column decode 116 is connected to a central processor 130 via a buffer 120.

A system clock generator 122 drives a sensing amplifier unit 112, a column decoder 116, a buffer 120, and a row decoder 103 through clock lines 123, 124, 125, and 126 respectively. A buffer 120 is connected to a central processor 130 by a system data bus 128. Signals are transmitted through a system data bus 128, a clock bus (123, 124, 125, and 126), and transmission lines between memory driver and memory array (106,110, and 114).

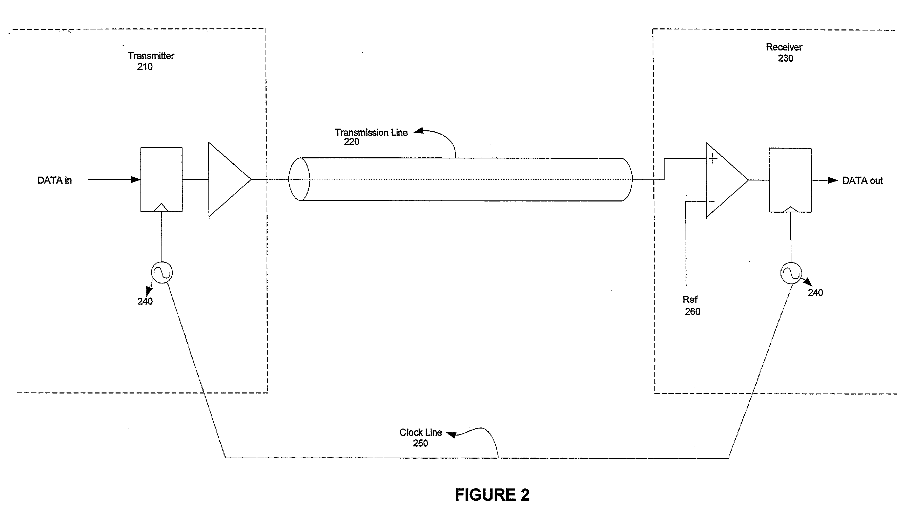

Figure 2 is an illustration of a signal flow path between a transmitter and a receiver in a DDR SDRAM. A transmitter unit 210 is connected to a receiver unit 230 by a transmission line 220. A transmitter unit 210 and a receiver unit 230 are synchronized to a system clock 240. A transmitter unit 210 encodes a data as a voltage/current signal level. A transmission line 220 delivers a signal from the transmitter unit 210 to a receiver unit 230. A receiver unit 230 compares signal with a reference 260 to recover the data which was sent. A clock 240 synchronizes the transmitter unit 210 and receiver unit 220 by a system clock bus 250. A clock signal tells a transmitter unit 210 when to drive a new signal and receiver unit 220 when to sample the received signal.

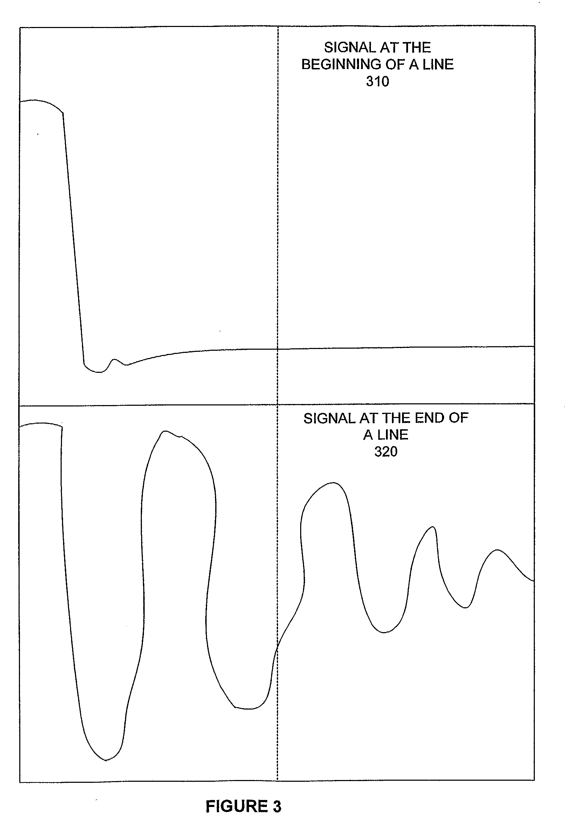

The reflection in a DRAM is caused by an impedance mismatch at any point on the signal path (transmission line 220). Reflection noise can distort data waveforms, and is particularly harmful when the reflection coincides with the data transitions at the receiver input. Figure 3 is an illustration of a signal form for a conventional CMOS DDR SDRAM. A signal 310 at the output of a transmitter unit 210 is a negative edge output of a conventional DDR SDRAM. A signal 310 starts of a transmission line 220 shows a required response due to a low resistance, considerable distortion occurs at the end of a transmission line 220 which is shown as a signal 320.

A distorted signal 320 is fed into the receiver unit 230 for decoding. If this transmission line 220 happens to be an address line (102 /106) then the distortion could result in the wrong memory cell to be addressed or if the line were to be a data-line( 110, 114,118 and 128) then data corruption is likely to occur. Clock lines( 123,124,125, and 126) are the most sensitive signal paths on the board. Reflections in a clock line can create transition inflections leading to false clocking or excessive skew. If a clock is chained from device to device the total skew between the first and last devices may be unacceptable.

Conventional methods to reduce reflections include termination and reducing signal rise and fall times. Reducing rise and fall times is an undesirable solution as it slows the arrival of the output signal at its destination, degrading the data transmission rate. A conventional line termination scheme are a resistive termination, a series resistive termination, and a resistive-capacitance termination.

Resistive termination scheme in prior art has a resistor of equal value connected between a transmission line and ground. The impedance of a typical transmission line is fairly 50 to 100 ohms and many transmitter units(drivers) can't source the current to that low impedance and even if a driver was strong enough, a 5V/50 ohm terminator consumes half a watt of power; terminating every line this way is impractical from power perspective.

A series resistive termination scheme in prior art has a resistor connected in series with a transmitter unit and receiver unit. The pull-up and pull-down impedance of a driver are often different and both vary by a factor of 2-3 over temperature and process. Choosing a compromise value of a resistor that works well in production requires very careful consideration and is often very difficult to determine. Moreover, the voltage in the circuit is initially halved and has a stair step waveform making it tricky to use with clock chains. This scheme posses an increase in transit delay (propagation delay) between intermediate nodes which is undesirable for faster circuits.

Resistive-Capacitance termination scheme in prior art has a capacitor in series with a resistor connected across a transmission line and a ground level. The biggest drawback of this scheme is that the capacitance value is dependent on signal rise time. The dependence of the scheme on capacitance value makes every output device with faster rise times to have a different capacitance value. In addition, the rise and fall times of a transmission lines are marginally lengthened, hence a resistive-capacitance termination is not an efficient scheme to terminate line reflections at higher frequencies.

If transmission lines are not properly terminated at their ends, the energy transported on a line is not consumed but instead reflected back into the line. These reflections lead to substantial signal distortions. Lack of proper termination at the high frequencies will cause reflections at the signal edges, which in turn will lead to false triggering of the digital logic and malfunction. A conventional random access memories such as SDRAMs or DDR SDRAMs does not have an efficient scheme to overcome this problem, hence making it very unreliable for faster clock operations.

The present invention provides a memory device with a N-MOS self-termination scheme which enables or disables the device to eliminate ringing and line reflections in a memory device such as a DDR SDRAM. The self-termination is achieved by using a weak N-MOS transistor. The N-MOS transistors are within the device and has an impedance of two to eight times of the characteristic impedance of a communication path in a memory device such as DRAM or SRDAM. The communication path is generally a read/write or command/address bus. The self-termination scheme terminates line reflections occurring in a device receiving data during non productive time duration of system clock. The present invention provides a method by which random access memories perform with faster settling time for data inputs and a high system performance.

The present invention will be described, by way of example, with reference to the accompany drawings, in which:
Figure 1 is a block diagram of a conventional DDR SDRAM;
Figure 2 is a flow diagram showing an overview of a data communication path in a conventional DDR SDRAM;
Figure 3 is a graphical chart of a negative edge data transfer period with respective to voltage and time for a conventional DDR SDRAM;
Figure 4 is a flow diagram showing an overview of a data communication path in one of the embodiments of the present invention;
Figure 5 is a graphical chart of a negative edge data transfer period with respective to voltage and time in one of the embodiments of the present invention;
Figure 6 is a schematic circuit diagram of one of the embodiments of the present invention with self termination scheme in a sense amplifier; and,
Figure 7 is a graphical chart of a clock signal, a data transfer period, a termination device gate signal and a device operating cycle with respect to time and voltage for one of the embodiments of the present invention.

The present invention relates to a self termination scheme of a double data rate (DDR) synchronous dynamic random access memory (SDRAM). In the following description, numerous specific details are set forth in order to provide a more thorough understanding of the present invention. It will be apparent, however, to one skilled in the art that the present invention may be practiced without these specific details. Further, this invention in one or more embodiments may be implemented in the form of hardware and/or software.

Thus, a method and apparatus for a self termination scheme in a DDR SDRAM is described in conjunction with one or more specific embodiments. Although the present invention has been described in considerable detail with regard to the preferred versions thereof, other versions are possible. The invention is defined by the claims and their full scope of equivalents.

### Self Termination Scheme

The present invention is a self-termination scheme in a memory device such as a DDR SDRAM. A self-termination scheme in a memory device eliminates or terminates the line reflections or ringing in transmission lines connected to a memory device. In the present invention a weak N-MOS transistor is implemented for the purpose of termination. A N-MOS transistor is connected to a transmission line (read/write or command/address path) of a DDR SDRAM. The arrangement of a N-MOS transistor makes it possible for pull-down the reflections in a transmission line.

A double data rate (DDR) synchronous dynamic random access memory (SDRAM) transfers data in synchronization with the system clock on both the rising and falling edge of the system clock signal. There is no data transfer when during a non-edge period of the clock signal. A termination device eliminates the communication path between input and output unit when there is no data transfer. This scheme saves lot of power and increases the performance of a DDR SDRAM device.

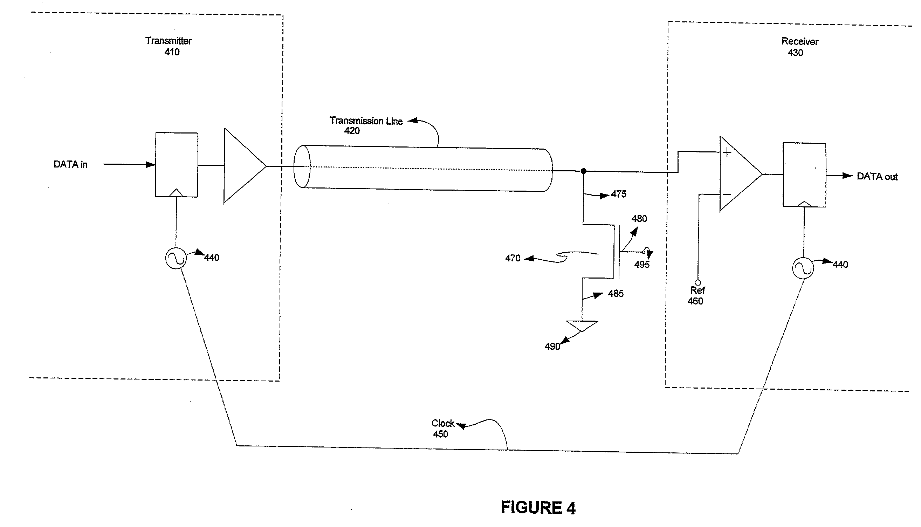

Figure 4 is an illustration of a signal flow path between a transmitter and a receiver in one of the embodiments of the present invention. A transmitter unit 410 is connected to a receiver unit 430 by a transmission line 420. A transmitter unit 410 and a receiver unit 430 are synchronized to a system clock 440. A transmitter unit 410 encodes a data as a voltage/current signal level. A transmission line 420 delivers a signal from the transmitter unit 410 to a receiver unit 430. A receiver unit 430 compares signal with a reference 460 to recover the data which was sent.

A clock 440 synchronizes the transmitter unit 410 and receiver unit 420 by a system clock bus 450. A clock signal tells a transmitter unit 410 when to drive a new signal and receiver unit 420 when to sample the received signal. A N-MOS transistor 470 is connected to a transmission line 420. The source terminal 475 of a N-MOS transistor 470 is connected to a transmission line 420. The drain terminal 485 of a N-MOS transistor 470 is connected to a ground 490. The gate terminal 480 of a N-MOS transistor 470 is connected to a control signal 495.

The reflection in a DRAM is caused by an impedance mismatch at any point on the signal path (transmission line 420). A N-MOS transistor 470 connected to a transmission line 420 eliminates the line reflections. A high signal is applied to the gate terminal 480 at 495 of a N-MOS transistor 470 after a transmission of data by a transmitter unit 410 to receiving unit 430. Any reflection signal from receiver is passed down to ground by a N-MOS transistor 470.

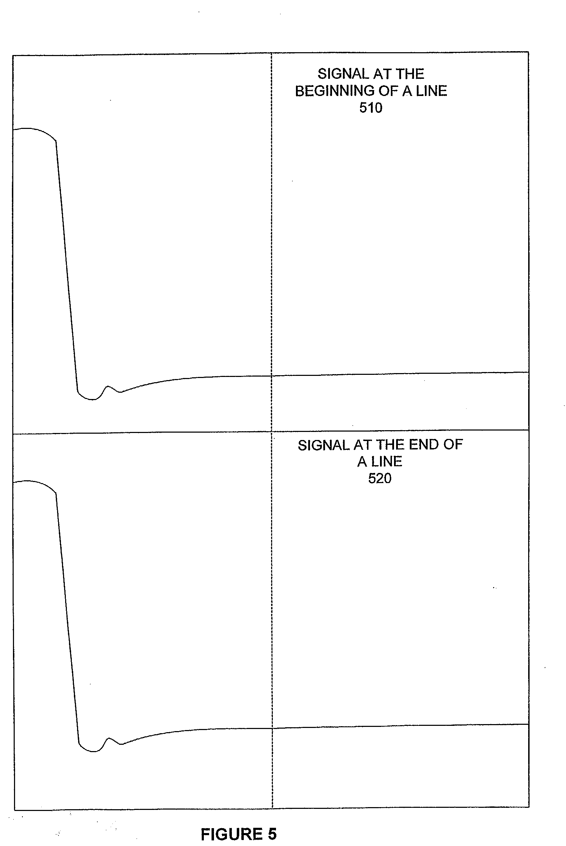

Figure 5 is an illustration of a signal form for one of the embodiments of the present invention. A signal 510 at the output of a transmitter unit 410 is a negative edge output. A signal 510 starts travelling through a transmission line 420 and reaches a receiving unit 430. Any considerable distortion occurring at the end of a transmission line 420 is reflected back in the transmission line 420. A N-MOS transistor 470 pulls down these reflection and terminates the reflection travelling back to a transmission unit 410. A signal which is eliminated from such line reflection is shown as a signal 520.

### Another Embodiment Of The Present Invention

A N-MOS transistor can be placed in any transmission line. In one of the embodiments of the present invention, a N-MOS transistor is connected to a sensing amplifier of a DDR SDRAM. The data is transferred in a DDR SDRAM only at the rising edge and falling edge of the system clock signal. The sensing amplifiers operate when there is a data transfer and the self termination device is not activated or "turned off" during this period. When there is no data transfer (steady high or steady low system clock period), the self-termination device is "turned on" which terminates any line reflection which might have occurred in sensing lines.

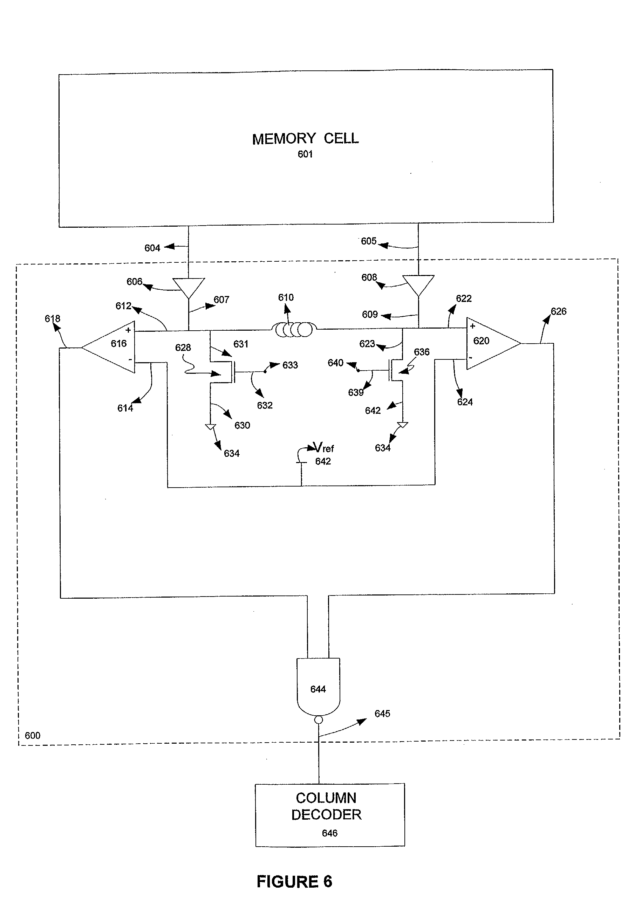

Figure 6 is a schematic circuit diagram of one of the embodiments of the present invention with self termination scheme in a sense amplifier. A DDR SDRAM has a sensing amplifier with a self-termination scheme 600. The outputs 604 and 605 of the memory cell 601 are connected to buffers 606 and 608 respectively. The output terminal 607 of the buffer 606 is connected to the non-inverting terminal 612 of a operational amplifier 616. The non-inverting terminal 612 of a operational amplifier 616 is also connected to the source terminal 631 of a N-MOS transistor 628. A N-MOS transistor 628 has the drain terminal 630 connected to a ground bias voltage reference 634 and the gate terminal 633 connected to the gate signal pulse at 633.

The output terminal 609 of the buffer 608 is connected to the non-inverting terminal 622 of a operational amplifier 622. The non-inverting terminal 622 of a operational amplifier 620 is also connected to the source terminal 623 of a N-MOS transistor 636. The N-MOS transistor 636 has the drain terminal 642 connected to a ground bias voltage reference 634, and the gate terminal 639 connected to the gate signal pulse at 640.

The gate signal for the self-terminating N-MOS transistors (628 and 636) controls enables the termination of any line reflection in the sensing lines 604, 605 and 610. The N-MOS transistors (628 and 636) can be enabled or disabled for a memory device receiving data on the communication bus or when the device is not selected. In the present invention the self-termination scheme is implemented to terminate a memory device receiving data and no termination on device driving the communication bus or on device not been selected.

The non-inverting terminals, 612 and 622, of the operational amplifiers 616 and 620 respectively are connected to each other and a line impedance between them is shown as 610. The inverting terminals 614 and 624 of the operational amplifiers 616 and 620 respectively are connected to a positive bias voltage reference at 642. The output terminals 618 and 626 of the operational amplifiers 616 and 620 respectively are connected to a NAND gate device 644. The output terminal 645 of the NAND gate device 644 is connected to a column decoder 646.

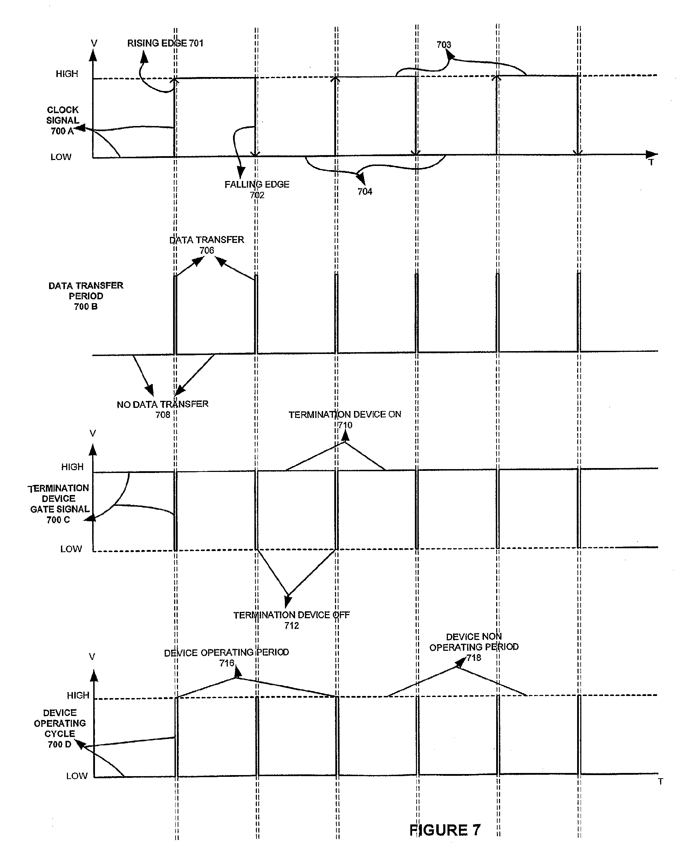

Figure 7 is a graphical representation of system clock signal, data transfer period, termination device gate signal and device operating cycle. The DDR SDRAM memory cells 601 is synchronized with the system clock signal 700a. The gate terminals 632 and 639 of N-MOS transistors 628 and 636 respectively are supplied to a gate signal 700c.

The gate signal is always high expect during data transfer time. When the gate signal is high 710 the N-MOS transistors 628 and 640 conduct. When the N-MOS transistors 628 and 640 conduct, it introduces a low impedance path for the current to flow, hence avoiding the path through the amplifiers 616 and 620. Thus, any reflection in the line is pulled-down to the ground through the amplifiers 616 and 620. The signal at the non-inverting terminals(612 and 622) of the amplifiers 616 and 620 are nearly equal to zero value, as the output signal from the memory cell follows through the N-MOS transistors 628 and 636.

When there is no signal at the gate terminals (612 and 622) of the amplifiers 616 and 620, the outputs of the amplifiers 616 and 620 are positive high signals or of the signal value transmitted from the memory cell 601 through transmission lines 604 and 605. The output terminals (618 and 626) of the amplifiers 616 and 620 are fed to the two input terminals of a NAND gate device 644. The output of a NAND gate 644 is connected to a column decoder 646 through 645. The output signal of a NAND gate 644 is decoded by a column decoder 646.

The process of eliminating ringing or line reflections in a transmission signal by temporarily pulling down a communication path for the signal to flow to ground in a DDR SDRAM using a N-MOS transistor is known as "N-MOS termination". The N-MOS transistor are not "turned-on" during the data transfer period (706), hence allowing the device to function with a positive signal output which is processed in a column decoder 646.

The N-MOS transistors (628 and 636) used for self-termination of the communication path as a impedance of two to eight times a characteristic impedance of DDR SRDAM communication path. Hence when the N-MOS transistors (628 and 636) do not conduct, the current flows through the amplifiers 616 and 620 through the non inverting terminals 612 and 622 respectively. The termination device off period 712 closely synchronized with the data transfer duration.

A device operating period 716 and non-operating period 718 of the present invention are illustrated in the device operating cycle 700d. A N-MOS transmission scheme in the present invention eliminates any line reflections and ringing in DDR SDRAM input and thus preventing any undershoot or overshoot of read/write signals. The present invention improves system performance by allowing faster settling times for a DDR SDRAM inputs.

Thus, a method and apparatus for a self termination scheme in a DDR SDRAM is described in conjunction with one or more specific embodiments. Although the present invention has been described in considerable detail with regard to the preferred versions thereof, other versions are possible. The invention is defined by the claims and their full scope of equivalents.

## Claims

1. An apparatus for terminating a communication path between a sender and a receiver comprising:
an impedance coupled between the communication path and ground, the impedance having an impedance value approximately two to eight times a characteristic impedance of said communication path.

2. The apparatus of claim 1, wherein the impedance comprises an active device for pulling the communication path to a low value in the absence of a signal on the communication path.

3. The apparatus of claim 2, wherein the active device comprises an NMOS transistor.

4. The apparatus of claim 3, wherein the communication path is a read/write or command/address path of a synchronous memory device.

5. The apparatus of claim 4, wherein the memory device comprises a dynamic random access memory, a synchronous dynamic random access memory, or a double data rate synchronous dynamic random access memory.

6. The apparatus of claim 5, wherein the transistor is internal to said memory device.

7. The apparatus of any one of claims 3 to 6, wherein the transistor is disabled when the path is being driven.

8. The apparatus of any one of claims 3 to 6, wherein the transistor is disabled when a system that includes the path is not currently selected.

9. The apparatus of any one of claims 3 to 6, wherein the transistor is disabled when a system including the path is in a low power state.
